(19) Europäisches Patentamt
European Patent Office
Office européen des brevets

(11) **EP 3 006 950 A1**

(12) **EUROPEAN PATENT APPLICATION**

(43) Date of publication:
13.04.2016 Bulletin 2016/15

(51) Int Cl.:
*G01R 31/36* [(2006.01)]       *H01M 16/00* [(2006.01)]

(21) Application number: 15182069.3

(22) Date of filing: 21.08.2015

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: 07.10.2014 CN 201410528265

(71) Applicant: **Optimum Battery Co., Ltd.
Shenzhen City, Guangdong 518118 (CN)**

(72) Inventors:
• **Li, Yao
Shenzhen Guangdong 518118 (CN)**
• **Chen, Jia jie
Shenzhen Guangdong 518118 (CN)**
• **Geng, De xian
Shenzhen Guangdong 518118 (CN)**

(74) Representative: **Blake, Michael Edward et al
Greaves Brewster LLP
Copa House
Station Road
Cheddar BS27 3AH (GB)**

(54) **ESTIMATION METHOD FOR STATE OF CHARGE OF LITHIUM IRON PHOSPHATE POWER BATTERY PACKS**

(57)    An estimation method for SOC of lithium iron phosphate power battery packs, include: 1, selecting a secondary battery (A) having characteristics of linear relationship between terminal voltage and SOC1; 2, connecting the secondary battery (A) with lithium iron phosphate power battery packs (B) in series, 3, repeatedly detecting values of the SOC1 and values the terminal voltages Ua of the secondary battery during the secondary battery is charging or discharging, fitting a formula (1) between the SOC1 and the terminal voltage Ua, the formula (1) being shown as following: $SOC1=K1*Ua+M1$ (1); 4, obtaining a formula (2) between SOC1 and SOC of the lithium iron phosphate power battery pack: $SOC1=K2*SOC+M2$ (2); 5, by formula (1) and formula (2), obtaining a formula (3) for calculating the SOC of the lithium iron phosphate power battery pack, the formula (3) being shown as following: $SOC=Ua*K1/K2+(M1-M2)/K2$ (3).

FIG. 3(c)

**Description**

BACKGROUND OF THE INVENTION

Field of the Invention

This disclosure relates to lithium iron phosphate power battery field, and more particular, to an estimation method for state of charge (SOC) of lithium iron phosphate battery packs.

Description of the Related Art

In order to address energy crisis and slow down global warming climate change, many countries have begun to pay attention to energy conservation and develop low-carbon economy. For using electric to drive electric vehicles, carbon dioxide emissions of electric vehicles can be reduced or even zero, therefore electric vehicles are being rapidly developed in many countries. However, the cost of batteries is still relatively high, performance price ratio of batteries are the main bottleneck for electric vehicles. However, lithium iron phosphate batteries become ideal power source for electric vehicles because of long life, good safety performance, and low cost.

According to development of electric vehicles, battery mange system (BMS) is widely applied. To maximize the power performance, improve usage safety, prevent overcharging or over-discharge, and longer battery life of the batteries, and improve the performance of electric vehicles, it is requires the BMS to accurately estimate the battery state of charge (SOC). The SOC is an important parameter used to describe charging or discharging capacity during the batteries working. A lot of facts are relative to the SOC, for example, temperature, charging or discharging condition at a prior moment, polarization effect, and life of batteries. For its strong nonlinearity characteristics, it is very inaccurate by a real-time estimation method for the SOC of the batteries.

Currently, estimation methods for the SOC mainly include open circuit voltage method, ampere time integration method, internal resistance method, artificial neural network method, and Kalman filter method, etc. For open circuit voltage method, it is need quietly place the batteries for a long time to estimate open circuit voltages, therefor it is not suit for real time estimation method for electric vehicles. For internal resistance method, it is difficult to estimate internal resistance of the batteries and also difficult to design hardware to measure the internal resistance. For artificial neural network method and Kalman filter method, they also do not have advantages because of complex system and high cost when applied in BMS. Therefore, ampere time integration method is usually used because of it simpler than open circuit voltage method, internal resistance method, artificial neural network method, and Kalman filter method. However, discharge current of electric vehicles fluctuates at various times, and in actual situation, it is impossible to achieve continuously testing discharge current between very short interval of time, therefore the SOC is usually also inaccurately acquired by ampere time integration method.

It is desirable to provide a disclosure, which can overcome the problems and limitations mentioned above.

SUMMARY OF THE INVENTION

The present invention is directed to an estimation method for SOC of a lithium iron phosphate battery pack that substantially obviates one or more of the problems due to limitations and disadvantages of the related art.

In an aspect of the present invention, there is provided an estimation method for SOC of lithium iron phosphate power battery packs, include the following steps: step 1, selecting a secondary battery (A) having characteristics of linear relationship between terminal voltage and $SOC_1$; step 2, connecting the secondary battery (A) with lithium iron phosphate power battery packs (B) in series, the lithium iron phosphate power battery packs (B) comprising a number of individual lithium iron phosphate power battery pack connected in series with each other; step 3, repeatedly detecting values of the $SOC_1$ and values the terminal voltages Ua of the secondary battery during the secondary battery is charging or discharging, fitting a formula (1) between the $SOC_1$ and the terminal voltage Ua, the formula (1) being shown as following: $SOC_1=K_1*Ua+M_1$ (1); step 4, obtaining a formula (2) between the $SOC_1$ and the SOC of the lithium iron phosphate power battery pack: $SOC_1=K_2*SOC+M_2$ (2); step 5, by formula (1) and formula (2), obtaining a formula (3) for calculating the SOC of the lithium iron phosphate power battery pack, the formula (3) being shown as following: $SOC=Ua*K_1/K_2+(M_1-M_2)/K_2$ (3); then real-time detecting values the terminal voltage Ua of the secondary battery, and the SOC of the lithium iron phosphate power battery pack can be calculated by the formula (3).

It is to be understood that both the foregoing general description and the following detailed description are exemplary and explanatory and are intended to provide further explanations of the invention as claimed.

BRIEF DESCRIPTION OF THE DRAWINGS

FIG. 1 is a circuit schematic diagram of lithium iron phosphate power battery packs of present disclosure connected with a secondary battery in series, the lithium iron phosphate power battery packs having a number of individual lithium iron phosphate power battery pack.

FIG. 2(a) is a function relationship diagram between terminal voltage and SOC of one lithium iron phosphate lithium power battery pack of FIG. 1, when the lithium iron phosphate lithium power battery pack is charging.

FIG. 2(b) is a function relationship diagram between terminal voltage and SOC of the secondary battery of FIG. 1, when the secondary battery is charging.

FIG. 2(c) is a function relationship diagram between terminal voltage and SOC of the lithium iron phosphate lithium power battery pack and a secondary battery connected in series of FIG. 1, when the lithium iron phosphate lithium power battery pack and the secondary battery connected in series are charging.

FIG. 3(a) is a function relationship diagram between the terminal voltage and the SOC of the lithium iron phosphate lithium power battery pack of FIG. 1, when the lithium iron phosphate lithium power battery packs are discharging.

FIG. 3(b) is a function relationship diagram between the terminal voltage and the SOC of the secondary battery of FIG. 1, when the secondary battery is discharging.

FIG. 3(c) is a function relationship diagram between the terminal voltage and the SOC of the lithium iron phosphate lithium power battery pack and the secondary battery connected in series of FIG. 1, when the lithium iron phosphate lithium power battery pack and the secondary battery connected in series are discharging.

FIG. 4 is a function relationship diagram between the SOC of the lithium iron phosphate lithium power battery pack and the SOC of the secondary battery (the SOC of the secondary battery is defined as $SOC_1$ hereafter).

DETAILED DESCRIPTION OF THE PREFERRED EMBODIMENTS

The disclosure will be described in detail in the following.

Since current equal everywhere in a series circuit, and based on the quantity of electric charge calculating formula: $Q=I*T$ (wherein Q is quantity of electric charge, T is time), it is can be known that a charging or discharging quantity of electric charge of each battery in a unit time are equal to those of other batteries when all of the batteries are connected in series. Therefore, only need to accurately calculate change of quantity of electric charge of one battery, it can get change of quantity of electric charge of all of the batteries connected in series. The present disclosure is based on the above principle, selects a secondary battery A to connect with lithium iron phosphate power battery packs B. The secondary battery A has characteristics of good linear relationship between terminal voltage and its SOC (the SOC of the secondary battery is defined as $SOC_1$). The lithium iron phosphate power battery packs B includes a number of individual lithium iron phosphate power battery pack connected in series with each other. Therefore, each individual lithium iron phosphate power battery pack and the secondary battery are connected is series. Each lithium iron phosphate power battery pack includes a number of lithium iron phosphate power battery cells connected in parallel. By accurately calculating quantity of electric charge of one of the lithium iron phosphate power battery pack, it can obtain quantity of electric charge of the lithium iron phosphate power battery packs B.

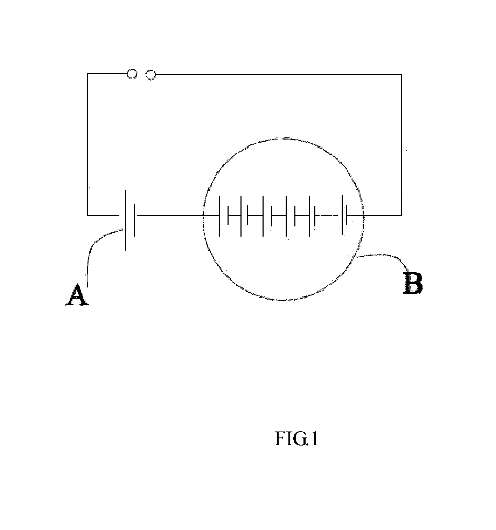

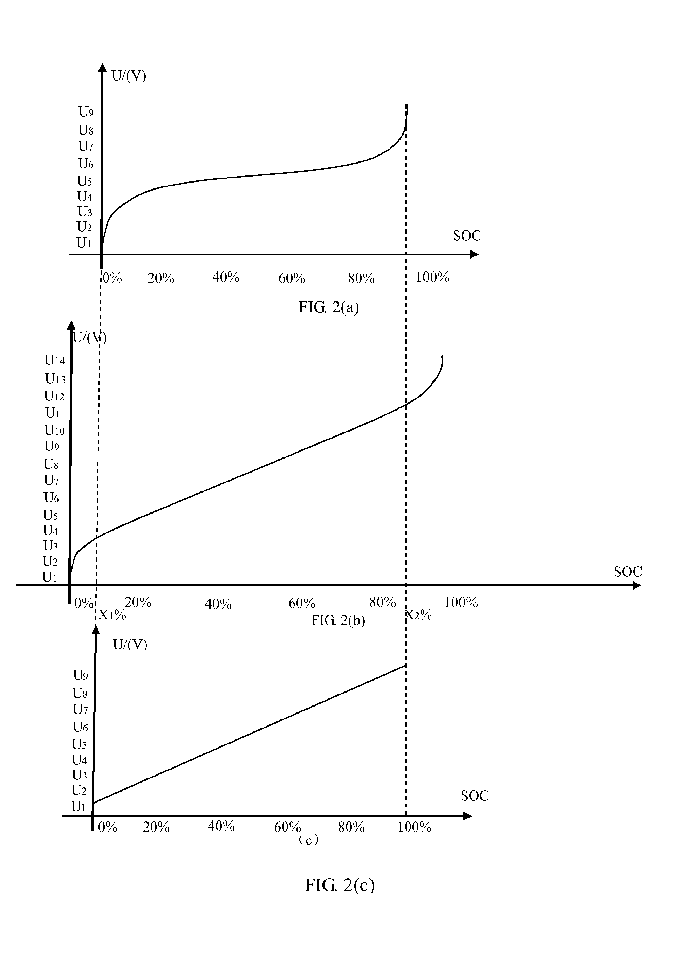

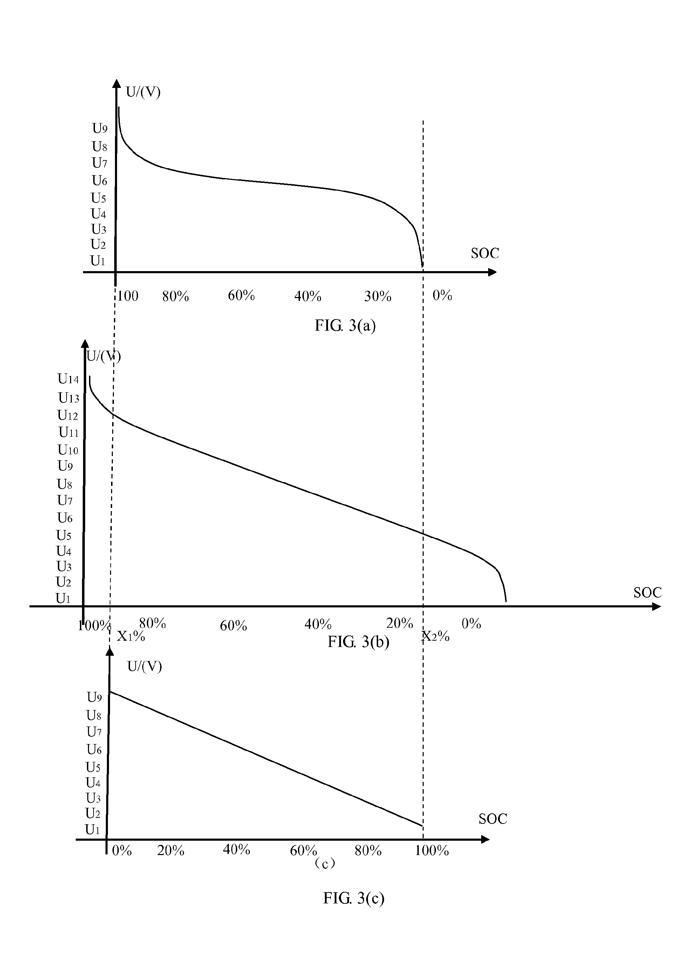

Refer to FIG. 2 (a) and FIG. 3 (a), FIG. 2(a) is a function relationship diagram between the terminal voltage and the SOC of one lithium iron phosphate lithium power battery pack of FIG. 1, when the lithium iron phosphate lithium power battery pack is charging. FIG. 3(a) is a formula relationship diagram between the terminal voltage and the SOC of the lithium iron phosphate lithium power battery pack of FIG. 1, when the lithium iron phosphate lithium power battery packs is discharging. It can be seen that in most of the time, terminal voltages of the lithium iron phosphate power battery pack are almost consistent when the lithium iron phosphate battery pack is charging or discharging, although the SOC of the lithium iron phosphate power battery pack continues to increase or decrease.

Refer to FIG. 2 (b) and FIG. 3 (b), FIG. 2(b) is a function relationship diagram between the terminal voltage and SOC of the secondary battery A of FIG. 1, when the secondary battery is charging. FIG. 3(b) is a function relationship diagram between the terminal voltage and the SOC (namely $SOC_1$) of the secondary battery A of FIG. 1, when the secondary battery A is discharging. The secondary battery A can be some type of secondary battery except for a lithium iron phosphate battery. During the secondary battery A charging and discharging, the terminal voltage of the secondary battery A changes according to $SOC_1$ of the secondary battery A, and showed a good linear relationship. Accordingly, when repeatedly detected values of the $SOC_1$ and values of the terminal voltages Ua of the secondary battery A during the secondary battery A is charging or discharging, it can be fitted a formula (1) between the $SOC_1$ of the secondary battery A and terminal voltage Ua of the secondary battery A, the formula (1) is shown as following:

$$SOC_1 = K_1 * Ua + M_1 \qquad\qquad (1)$$

Wherein, $K_1 \neq 0$, $K_1$ and $M_1$ are constant, $SOC_1 \in (X_1, X_2)$; wherein $X_1$ and $X_2$ are set in accordance with the following rules: during the secondary battery and lithium iron phosphate power battery pack connected in series charging and discharging, when the SOC of one of the lithium iron phosphate power battery pack are 0% and 100%, the $SOC_1$ of the secondary battery are set to be $X_1$ and $X_2$ respectively corresponding to 0% and 100%.

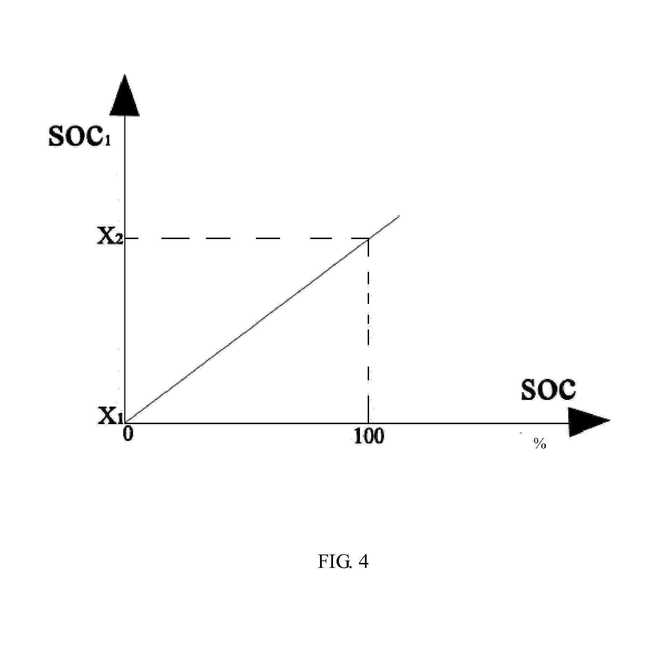

Refer to FIG. 2 (c) and FIG. 3 (c), according to the above settings, during the secondary battery and one lithium iron phosphate power battery pack connected in series charging and discharging, when the SOC of the lithium iron phosphate power battery pack is 0%, the $SOC_1$ of the secondary battery is $X_1$ correspondingly, when the SOC of the lithium iron phosphate power battery pack is 100%, the $SOC_1$ of the secondary battery is $X_2$ correspondingly. Because the SOC of the lithium iron phosphate power battery packs and the $SOC_1$ of the secondary battery represent the same physical characterization (namely stage of charge), therefore the SOC the lithium iron phosphate power battery pack and the $SOC_1$ of the secondary battery can be established mathematical model in the same coordinate system. Refer to FIG. 4, specific mathematical model is described as follows: the $SOC_1$ of the secondary battery is deemed as the vertical coordinate, the SOC of the lithium iron phosphate power battery pack is deemed as the horizontal coordinate, and the mathematical model can be established, the two coordinate points (0%, $X_1$), (100%, $X_2$) in the coordinate system are gotten, therefor a formula (2) between the $SOC_1$ of the secondary battery and the SOC of the lithium iron phosphate power battery pack is obtained. The formula (2) is shown as following:

$$SOC_1 = K_2 * SOC + M_2 \qquad\qquad (2)$$

Wherein $K_2 \neq 0$, $M_2$ is constant.

By formula (1) between the $SOC_1$ the terminal voltage Ua of the secondary battery and formula (2) between the $SOC_1$ of the secondary battery and the SOC of the lithium iron phosphate power battery pack. A formula (3) for calculating the SOC of the lithium iron phosphate power battery pack is obtained. The formula (3) is shown as following:

$$SOC = Ua * K_1 / K_2 + (M_1 - M_2) / K_2 \qquad\qquad (3)$$

Then by real-time detecting values the terminal voltage Ua of the secondary battery, the SOC of the lithium iron phosphate power battery pack can be calculated by the formula (3). Furthermore, the SOC of the lithium iron phosphate power battery packs can be obtained through the SOC of the lithium iron phosphate power battery pack.

According to above described method for the SOC the lithium iron phosphate power battery pack, the secondary battery connected with the lithium iron phosphate power battery packs in series must have the following characteristics: first, function curve between values of the terminal voltage Ua and values of the $SOC_1$ corresponding to Ua has good linearity relationship; second, when the terminal voltage Ua of the secondary battery changes, it can cause significant changes to the $SOC_1$ of the secondary battery; third, self-loss of the secondary battery is less than or equal to self-loss of one lithium iron phosphate power battery pack; forth, capacity of the secondary battery must be larger than capacity of one lithium iron phosphate power battery pack, for example, the capacity of the secondary battery is ranged from 1.3 to 2 times of the capacity of one lithium iron phosphate battery pack; fifth, the secondary battery has long service life.

The capacity of the secondary battery must be larger than the capacity of one lithium iron phosphate power battery pack, for example, the capacity of the secondary battery is ranged from 1.3 to 2 times of the capacity of one lithium iron phosphate battery pack. This can help the secondary battery does not occur over-charge and over-discharge during the lithium iron phosphate power battery pack charging and discharging, thus ensuring the terminal voltage Ua and the $SOC_1$ of the secondary battery has a good linear relationship during the secondary battery is charging and discharging, meanwhile also extending the life of the secondary battery.

Refer to 1 to FIG.4, an estimation method for the SOC of the lithium iron phosphate power battery packs, includes the following steps:

Step 1, selecting a secondary battery A having characteristics of good linear relationship between terminal voltage and SOC (the SOC of the secondary battery is defined as $SOC_1$).

Step 2, connecting the secondary battery A with lithium iron phosphate power battery packs B in series. The lithium iron phosphate power battery packs B includes a number of individual lithium iron phosphate power battery pack connected in series with each other. Each individual lithium iron phosphate power battery pack and the secondary battery are connected in series. Each lithium iron phosphate power battery pack further includes a number of lithium iron phosphate power battery cells connected in parallel. And during the secondary battery and one lithium iron phosphate power battery pack connected in series charging and discharging, when the SOC of one lithium iron phosphate power battery pack are 0% and 100%, the $SOC_1$ of the secondary battery are $X_1$ and $X_2$ respectively correspondingly set to be 0% and 100%.

Step 3, repeatedly detecting values of the $SOC_1$ and values the terminal voltages Ua of the secondary battery during the secondary battery is charging or discharging, fitting a formula (1) between the $SOC_1$ of the secondary battery and terminal voltage Ua of the secondary battery, the formula (1) is shown as following:

$$SOC_1 = K_1 * Ua + M_1 \qquad (1)$$

Wherein, $K_1 \neq 0$, $K_1$ and $M_1$ are constant, $SOC_1 \in (X_1, X_2)$.

Step 4, the $SOC_1$ of the secondary battery being deemed as the vertical coordinate, the SOC of the lithium iron phosphate power battery pack being deemed as the horizontal coordinate, and the mathematical model can be established, getting two coordinate points $(0\%, X_1)$, $(100\%, X_2)$ in the coordinate system, therefor a formula (2) between the $SOC_1$ of the secondary battery and the SOC of the lithium iron phosphate power battery pack is obtained. The formula (2) is shown as following:

$$SOC_1 = K_2 * SOC + M_2 \qquad (2)$$

Wherein $K_2 \neq 0$, $M_2$ is constant.

Step 5, by formula (1) between the $SOC_1$ the terminal voltage Ua of the secondary battery and formula (2) between the $SOC_1$ of the secondary battery and the SOC of the lithium iron phosphate power battery pack. A formula (3) for calculating the SOC of the lithium iron phosphate power battery pack is obtained. The formula (3) is shown as following:

$$SOC = Ua * K_1 / K_2 + (M_1 - M_2) / K_2 \qquad (3)$$

Then real-time detecting values the terminal voltage Ua of the secondary battery, the SOC of the lithium iron phosphate power battery pack can be calculated by the formula (3). Furthermore, the SOC of the lithium iron phosphate power battery packs can be obtained through the SOC of the lithium iron phosphate power battery pack.

The secondary battery of the estimation method for the SOC of the lithium iron phosphate power battery packs in the present disclosure can be selected from some type of secondary battery or a super battery except for a lithium iron phosphate power battery. In order to ensure that the secondary battery maintains its good linear relationship between the terminal voltage Ua and the $SOC_1$ during the secondary battery charging and discharging, preferably, $2\% < X_1 < 7\%$, $86\% < (X_2 - X_1) < 96\%$, namely, during charging and discharging, quantity of electric charge of the lithium iron phosphate power battery pack changes from 0 to 100%, it does not require the secondary battery to be fully charged or fully discharged. Values of terminal voltage Ua of the secondary battery connected with lithium iron phosphate battery packs in series can be measured by a battery management system (BMS).

The estimation method for the SOC of the lithium iron phosphate power battery packs in the present disclosure, U1, U2, U3, U4, U5, U6,... U14 are specific values in the coordinate system, there can be more specific values according to actual requirements.

The number of the individual lithium iron phosphate lithium power battery packs can be one or more than one.

It will be apparent to those skilled in the art that various modification and variations can be made in the multicolor illumination device and related method of the present invention without departing from the spirit or scope of the invention. Thus, it is intended that the present invention cover modifications and variations that come within the scope of the appended claims and their equivalents.

**Claims**

1. An estimation method for SOC of lithium iron phosphate power battery packs, **characterized in that** the estimation method comprising the following steps:

   step 1, selecting a secondary battery (A) having characteristics of linear relationship between terminal voltage and SOC, and defining the SOC of the secondary battery as $SOC_1$;

step 2, connecting the secondary battery (A) with lithium iron phosphate power battery packs (B) in series, the lithium iron phosphate power battery packs (B) comprising a number of individual lithium iron phosphate power battery pack connected in series with each other; during the secondary battery and one lithium iron phosphate power battery pack connected in series charging and discharging, when the SOC of one lithium iron phosphate power battery pack being 0% and 100%, setting the $SOC_1$ of the secondary battery are $X_1$ and $X_2$ respectively correspondingly to be 0% and 100%;

step 3, repeatedly detecting values of the $SOC_1$ and values the terminal voltages Ua of the secondary battery during the secondary battery is charging or discharging, fitting a formula (1) between the $SOC_1$ and the terminal voltage Ua, the formula (1) being shown as following:

$$SOC_1 = K_1 * Ua + M_1 \qquad\qquad (1)$$

wherein, $K_1 \neq 0$, $K_1$ and $M_1$ are constant, $SOC_1 \in (X_1, X_2)$;

step 4, deeming the $SOC_1$ of the secondary battery as the vertical coordinate, the SOC of the lithium iron phosphate power battery pack as the horizontal coordinate, establishing mathematical model, getting two co-ordinate points (0%, $X_1$), (100%, $X_2$) in the coordinate system, and obtaining a formula (2) between the $SOC_1$ and the SOC of the lithium iron phosphate power battery pack:

$$SOC_1 = K_2 * SOC + M_2 \qquad\qquad (2)$$

wherein $K_2 \neq 0$, $M_2$ is constant.

step 5, by formula (1) between the $SOC_1$ the terminal voltage Ua of the secondary battery and formula (2) between the $SOC_1$ of the secondary battery and the SOC of the lithium iron phosphate power battery pack, obtaining a formula (3) for calculating the SOC of the lithium iron phosphate power battery pack, the formula (3) being shown as following:

$$SOC = Ua * K_1/K_2 + (M_1 - M_2)/K_2 \qquad\qquad (3)$$

then real-time detecting values the terminal voltage Ua of the secondary battery, and the SOC of the lithium iron phosphate power battery pack can be calculated by the formula (3).

2. The estimation method for SOC of lithium iron phosphate power battery packs of claim 1, **characterized in that** obtaining the SOC of the lithium iron phosphate power battery packs can be obtained through the SOC of the lithium iron phosphate power battery pack.

3. The estimation method for SOC of lithium iron phosphate power battery packs of claim 1, **characterized in that** 2% < $X_1$ < 7%, 86% < ($X_2$ - $X_1$) < 96%.

4. The estimation method for SOC of lithium iron phosphate power battery packs of claim 1, **characterized in that** the secondary battery is selected from some type of secondary battery or a super battery except for a lithium iron phosphate power battery.

5. The estimation method for SOC of lithium iron phosphate power battery packs of claim 4, **characterized in that** values of terminal voltage Ua of the secondary battery connected with lithium iron phosphate battery packs in series can be measured by a battery management system.

6. The estimation method for SOC of lithium iron phosphate power battery packs of claim 1, **characterized in that** a capacity of the secondary battery is larger than the capacity of one lithium iron phosphate power battery pack.

7. The estimation method for SOC of lithium iron phosphate power battery packs of claim 6, **characterized in that** the capacity of the secondary battery is ranged from 1.3 to 2 times of the capacity of the lithium iron phosphate battery pack.

8. The estimation method for SOC of lithium iron phosphate power battery packs of claim 1, **characterized in that** each lithium iron phosphate power battery pack includes a number of lithium iron phosphate power battery cells connected in parallel.

FIG.1

FIG. 2(a)

FIG. 2(b)

（c）

FIG. 2(c)

FIG. 3(a)

FIG. 3(b)

FIG. 3(c)

FIG. 4

Europäisches
Patentamt

European
Patent Office

Office européen
des brevets

# EUROPEAN SEARCH REPORT

Application Number

EP 15 18 2069

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2012 003100 A1 (DAIMLER AG [DE]) 7 February 2013 (2013-02-07) * abstract; figures 1,2 * * paragraphs [0001], [0004], [0008] - [0014], [0021] - [0024] * | 1-8 | INV. G01R31/36 H01M16/00 |
| X | US 2010/225325 A1 (CHRISTENSEN JOHN F [US] ET AL) 9 September 2010 (2010-09-09) * abstract; figures 1-6 * * paragraphs [0002] - [0010], [0019] - [0036] * | 1-8 | |
| X | WO 2013/159979 A1 (BOSCH GMBH ROBERT [DE]) 31 October 2013 (2013-10-31) * abstract; figures 1-4 * * page 1, paragraph 1 - page 5, paragraph 1 * * page 6, paragraph 6 - page 9, paragraph 1 * | 1-5,8 | |

TECHNICAL FIELDS
SEARCHED       (IPC)

G01R
H01M

The present search report has been drawn up for all claims

| Place of search | Date of completion of the search | Examiner |
|---|---|---|
| Munich | 29 February 2016 | Kleiber, Michael |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 15 18 2069

This annex lists the patent family members relating to the patent documents cited in the above-mentioned European search report.
The members are as contained in the European Patent Office EDP file on
The European Patent Office is in no way liable for these particulars which are merely given for the purpose of information.

29-02-2016

| Patent document cited in search report | Publication date | Patent family member(s) | | Publication date |
|---|---|---|---|---|
| DE 102012003100 A1 | 07-02-2013 | NONE | | |
| US 2010225325 A1 | 09-09-2010 | EP | 2435841 A1 | 04-04-2012 |
| | | US | 2010225325 A1 | 09-09-2010 |
| | | WO | 2010101830 A1 | 10-09-2010 |
| WO 2013159979 A1 | 31-10-2013 | DE | 102012206893 A1 | 31-10-2013 |
| | | WO | 2013159979 A1 | 31-10-2013 |

EPO FORM P0459

For more details about this annex : see Official Journal of the European Patent Office, No. 12/82